# FASCICULE DE BREVET EUROPEEN

(11) **EP 0 371 855 B1**
(45) Date de publication et mention de la délivrance du brevet: **04.06.1997**
(21) Numéro de dépôt: 89403236.6
(22) Date de dépôt: 23.11.1989
(51) Int. Cl.: H01L 21/56, H01L 23/31, G06K 19/06

(54) **Procédé de réalisation d'un module électronique et module électronique tel qu'obtenu par ce procédé**
Verfahren zur Herstellung eines elektronischen Moduls und elektronisches Modul, hergestellt nach diesem Verfahren
Method of manufacturing an electronic module, and electronic module made by this method

(30) Priorité: 29.11.1988 FR 8815553
(43) Date de publication de la demande: 06.06.1990
(73) Titulaire: SCHLUMBERGER INDUSTRIES, F-92120 Montrouge (FR)
(72) Inventeur: Rose, René, F-78190 Voisin le Bretonneux (FR)
(74) Mandataire: Hasenrader, Hubert

(56) Documents cités:
- EP-A- 0 068 539
- EP-A- 0 197 438
- FR-A- 2 520 541
- PATENT ABSTRACTS OF JAPAN, vol. 8, no. 99 (E-243)[1536], 10 mai 1984; & JP-A-59 017 274

## Description

La présente invention a pour objet un procédé de réalisation d'un module électronique destiné à être incorporé dans une carte à mémoire électronique et un module électronique tel qu'obtenu par la mise en oeuvre de ce procédé.

Les cartes à mémoire électronique permettant à leurs titulaires d'effectuer un certain nombre de transactions sont maintenant bien connues. On sait que la carte se compose essentiellement d'un corps en matière plastique dans lequel est logé un module électronique comportant une pastille semi-conductrice, des plages de contact pour assurer la connexion avec le lecteur de carte, des zones de connexion électrique et des moyens de liaison pour relier électriquement les bornes de la pastille semi-conductrice aux zones de connexion électrique.

En général, le module électronique est réalisé à l'aide d'une technique de circuit imprimé connue. On peut aussi utiliser la technique dite du cadre conducteur (en anglais lead-frame) décrite dans une demande de brevet européen de la demanderesse 0254640. Cette technique utilise un ensemble de conducteurs électriques ou cadre conducteur réalisé, de préférence, dans une bande en matériau métallique conducteur de 0,1 mm d'épaisseur environ à l'aide par exemple d'un alliage cuivre-fer. Ce cadre conducteur est muni de fentes pour séparer les conducteurs métalliques les uns des autres, les différents conducteurs étant mécaniquement reliés entre eux par des ponts. Après la fixation du module électronique sur le corps de carte, ces ponts sont coupés pour obtenir la configuration souhaitée de conducteurs.

Cette technique générale est celle de l'invention.

Le module électronique comprend donc un ensemble de conducteurs électriques présentant une première et une deuxième face, et une pastille semi-conductrice fixée directement sur la deuxième face de l'ensemble de conducteurs. Le corps de carte présente généralement une première et une deuxième face dans lequel sont ménagés un premier évidement débouchant dans la première face du corps de carte pour recevoir l'ensemble de conducteurs électriques, un deuxième évidement débouchant dans le fond du premier évidement pour recevoir la pastille semi-conductrice. Une technique de fixation du module électronique sur le corps de carte est aussi décrite dans la demande de brevet européen n° 0 254 640.

Le document JP-A-59 17274 décrit un encapsulage de circuit intégré par moulage d'une pièce en matériau plastique sur un lead-frame. Cependant, cette forme d'encapsulage n'est pas utilisable dans une carte à mémoire électronique.

Les documents EP-A-068 539 et EP-A-197 438 décrivent des techniques de réalisation de modules électroniques pour cartes à mémoire à partir d'un lead-frame. Cependant, les techniques qui y sont décrites ne permettent pas d'assurer une liaison mécanique efficace entre le lead-frame et le matériau plastique d'enrobage.

Un objet de l'invention est de fournir un procédé de réalisation d'un module électronique qui fasse appel aux techniques de moulage permettant la diminution des coûts de fabrication.

Le procédé de réalisation d'un module électronique selon l'invention comprend les étapes suivantes:
a) on fournit un ensemble A de conducteurs électriques 13 à 20 formant cadre conducteur (lead-frame) présentant une première 10a et une deuxième face 10b, pour définir des plages de contact externe 24 pour ladite carte situées sur ladite première face dudit ensemble, lesdites plages de contact externe étant disposées dans un premier plan PP, des zones de connexion électrique 26 et une zone de fixation 34 d'une pastille semi-conductrice 35 situées sur ladite deuxième face dudit ensemble et des portions d'extrémité 28 raccordées à la périphérie des plages de contact externe par des coudes de pliage 29 de telle manière que lesdites portions d'extrémité soient disposées dans un plan intermédiaire RR disposé parallèle et en retrait par rapport audit premier plan;
b) on fournit un moule M dont l'empreinte définit la forme extérieur dudit module électronique destiné à être incorporé dans une carte à mémoire, ladite empreinte présentant une face sensiblement plane pour constituer la face externe du module électronique, ledit moule comportant des moyens de protection pour éviter le dépôt du matériau de moulage entre lesdits moyens de protection et lesdites plages de contact externe 24, lesdites zones de connexion électrique 26, et ladite zone de fixation d'une pastille semi-conductrice 34, lesdits moyens de protection comportant des moyens pour maintenir les plages de contact externe contre ladite face sensiblement plane;
c) on place ledit ensemble A de conducteurs électriques 13 à 20 dans ledit moule M;
D) on injecte dans ledit moule ledit matériau de moulage pour que celui-ci remplisse ladite empreinte dudit moule, lesdites portions d'extrémité 28 étant alors noyées dans ledit matériau de moulage;
e) on démoule la pièce ainsi obtenue;
f) on fixe ladite pastille semi-conductrice 35 sur ladite zone de fixation 34; et
g) on réalise une liaison électrique entre les bornes 37 de ladite pastille semi-conductrice 35 et lesdites zones de connexion électrique 26.

L'invention concerne également un module électronique d'une carte à mémoire électronique comprenant un ensemble A de conducteurs électriques 13 à 20 formant cadre conducteur (lead-frame), présentant une première 10a et une deuxième face 10b, pour définir des plages de contact externe 24 de ladite carte situées sur ladite première face dudit ensemble, lesdites plages de contact externe étant disposées dans un premier plan PP, des zones de connexion électrique 26 et une zone de fixation 34 d'une pastille semi-conductrice situées sur ladite deuxième face dudit ensemble, une pièce moulée définissant une cavité 41 pour une pastille semi-conductrice 35, et présentant une face sensiblement plane dans laquelle sont disposées lesdites plages de contact externe 24, une pastille semi-conductrice 35 fixée sur ladite zone de fixation et des moyens de liaison 38 pour relier électriquement les bornes 37 de ladite pastille auxdites zones de connexion électrique, ledit cadre conducteur comprenant en outre des portions d'extrémité caractérisé en ce que ces portions d'extrémité sont raccordées à la périphérie des plages de contact externe par des coudes de pliage de telle manière que lesdites portions d'extrémité soient disposées dans un plan intermédiaire RR situé parallèle et en retrait par rapport audit premier plan, lesdites portions d'extrémité étant noyées dans ladite pièce moulée.

Selon un mode particulier de réalisation du module électronique, ladite pièce moulée est composée d'une part d'une plate forme moulée située du côté de ladite deuxième face dudit ensemble, lesdites zones de connexion électrique reposant sur ladite plate forme moulée, d'autre part d'une barrière moulée, située du côté de ladite deuxième face dudit ensemble, délimitant ladite cavité dans laquelle sont disposés ladite pastille semi-conductrice, ladite plate-forme moulée, lesdites zones de connexion électrique reposant sur ladite plate-forme moulée et lesdits moyens de liaison pour relier électriquement lesdites bornes de ladite pastille auxdites zones de connexion électrique.

La technique du moulage permet d'obtenir une pièce moulée à des cotes précises, telles que définies dans le cahier des charges. Cette souplesse d'utilisation permet d'adapter les cotes du moulage en fonction des besoins. La forme de la pastille semi-conductrice, ses caractéristiques dimensionnelles déterminent entre autres les cotes du moulage. Lors de l'insertion du module électronique dans le corps de carte, la pièce moulée se loge parfaitement dans les évidements creusés dans le corps de carte. En effet, la barrière moulée évite l'écoulement du materiau d'enrobage isolant, ledit écoulement pouvant empêcher l'insertion du module électronique dans le deuxième évidement creusé dans le corps de carte pour des problèmes d'encombrement. L'usinage du module électronique permettant son insertion dans le corps de carte n'est plus nécessaire et les rebuts sont nettement moins nombreux, ce qui abaisse d'autant les coûts de fabrication.

Un autre avantage de l'invention est la reproductibilité des pièces moulées fabriquées. Les dimensions du moule définissent les cotes du moulage, permettant ainsi l'automatisation de la chaîne de fabrication des pièces moulées aux cotes voulues.

D'autres caractéristiques et avantages de l'invention apparaitront plus clairement à la lecture de la description qui suit, de plusieurs modes de mise en oeuvre de l'invention donnés à titre d'exemples non limitatifs. La description se réfère au dessin annexé sur lequel :
- les figures 1 et 2 sont des vues de dessus d'un cadre conducteur ("lead-frame") ;
- la figure 3 est une demi-vue en coupe verticale du cadre conducteur selon le plan III-III de la figure 1 ;
- les figures 4a, 4b, 4c sont des demi-vues en coupe verticale montrant les différents modes de réalisation de pliage du cadre conducteur ;
- la figure 5 est une demi-vue en coupe verticale d'un moule contenant le cadre conducteur plié ;
la figure 6 est une vue en coupe verticale partielle du module électronique surmoulé ;
- la figure 7 est une vue de dessous du module électronique surmoulé représenté sur la figure 6..

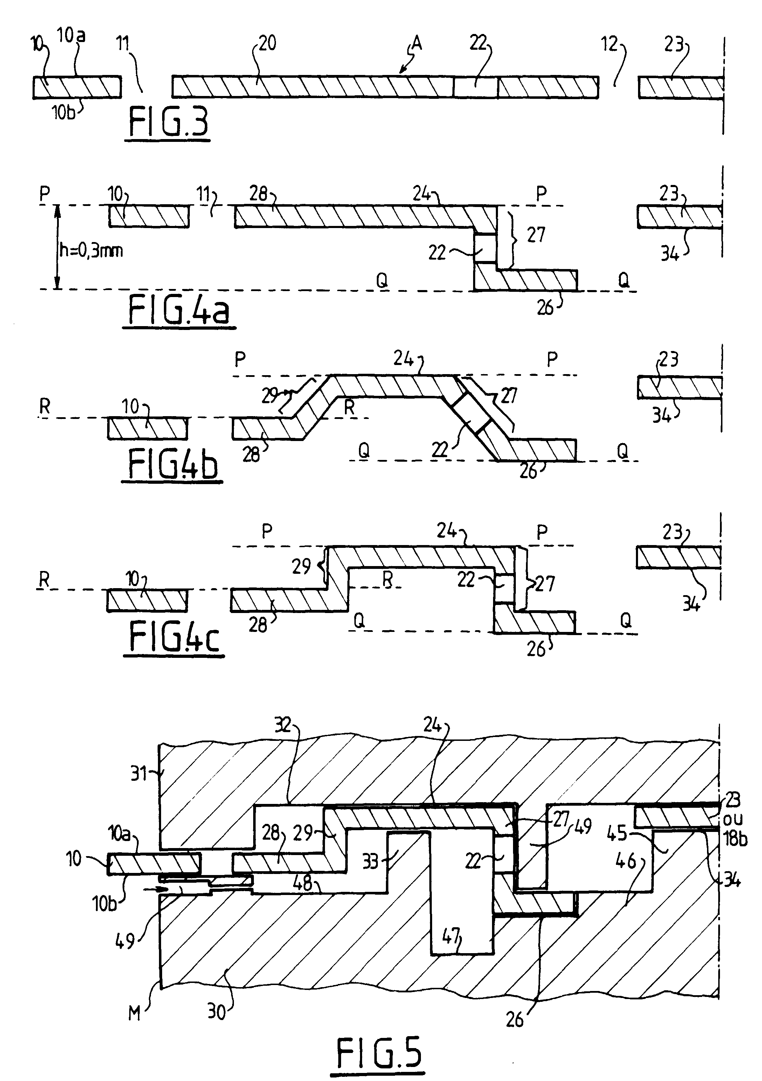

Les demi-vues en coupe verticale des figures 3, 4 et 5 sont symétriques aux parties non représentées sur les mêmes figures.

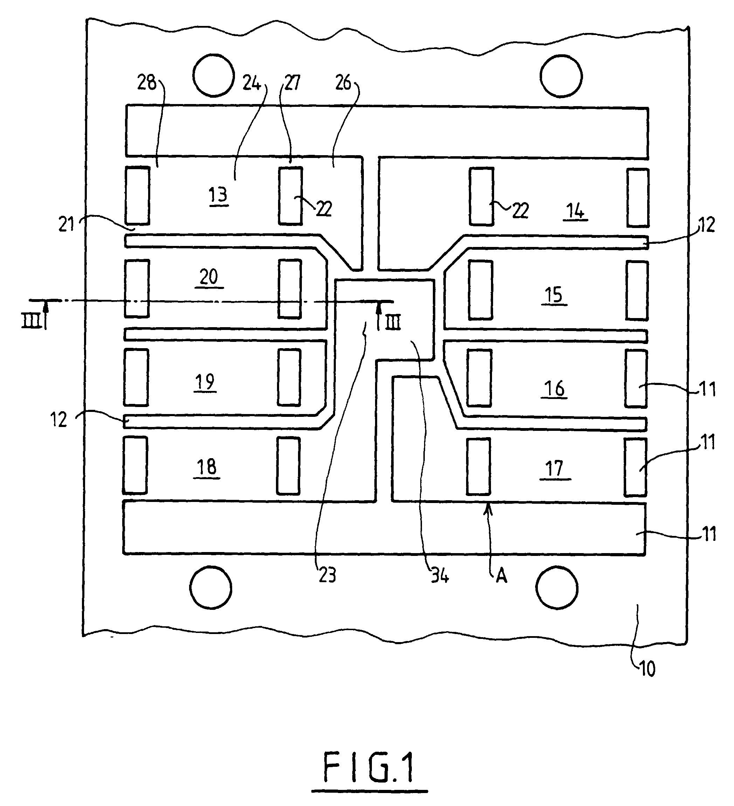

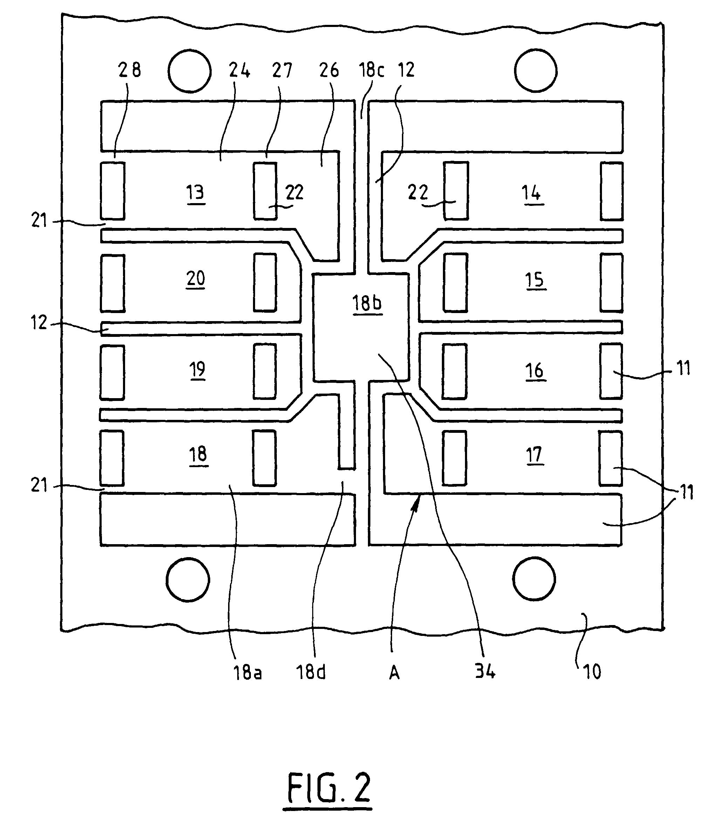

En se référant tout d'abord aux figures 1 et 2, on va décrire deux modes de réalisation d'ensemble de conducteurs électriques, de cadre conducteur ou "lead-frame". De préférence le cadre conducteur est réalisé dans une bande en matériau métallique conducteur 10 présentant une face supérieure 10a et une face inférieure 10b. Sur une même bande, on peut réaliser une pluralité de cadres conducteurs, un seul cadre référencé A étant représenté sur les figures 1 et 2.

La portion de la bande 10 correspondant à la partie utile du cadre conducteur est limitée par des fentes de pré-découpages telles que 11. A l'intérieur de cette surface, la bande métallique 10 est percée de fentes telles que 12 qui séparent ainsi les unes des autres différentes zones conductrices référencées 13 à 20. Chaque zone conductrice 13 à 20 comprend depuis son extrémité libre jusqu'à la périphérie du cadre conducteur A : une zone de connexion électrique 26, une portion de pliage 27 munie d'une fenêtre 22, une plage de contact externe 24 et une portion d'extrémité 28.

Pour assurer l'intégrité mécanique de cet ensemble (A), on laisse subsister des ponts d'interconnexion tels que 21.

La zone conductrice 18, constitue de plus le contact de masse de la pastille semi-conductrice et comprend une zone de fixation 34 pour ladite pastille semi-conductrice située sur la face inférieure 10b du cadre conducteur A.

Selon un premier mode de réalisation de cadre conducteur A illustré par la figure 1, l'extrémité 23 de la zone conductrice 18 située au-delà de la zone de connexion 26 sur laquelle on fixera la pastille semi-conductrice, est disposée sensiblement au centre de la partie utile du cadre conducteur A.

Selon un second mode de réalisation de cadre conducteur A illustré par la figure 2, la zone conductrice 18 présente une configuration sensiblement différente. Elle se compose d'une partie conductrice 18a reliée à la bande 10 par l'intermédiaire des ponts 21, d'une partie 18b sur laquelle on fixera la pastille semi-conductrice disposée sensiblement au centre de la partie utile du cadre conducteur reliée à la bande 10 par l'intermédiaire de couloirs métalliques 18c, les parties 18a et 18b avec ses couloirs métalliques 18c étant connectées par un pont 18d.

On expliquera ultérieurement l'intérêt de cette configuration de la zone 18 illustrée par la figure 2.

La partie 18b de la zone conductrice 18 illustrée par la figure 2 a un rôle équivalent à celui de l'extrémité 23 de la zone conductrice 18 illustrée par la figure 1 en ce sens que ladite partie 18b et ladite extrémité 23 possèdent ladite zone de fixation 34 pour ladite pastille semi-conductrice, située sur la face inférieure 10b du cadre conducteur A.

La figure 3 est une demi-vue en coupe verticale du cadre conducteur A selon la figure 1 et de la bande 10. Ce cadre conducteur A et la bande 10 vont ensuite subir un pliage réalisé par des moyens de presse classiques selon divers modes de réalisations illustrés par les figures 4a, 4b, 4c qui représentent des demi-vues en coupe verticale du cadre conducteur A et de la bande 10 pliés.

Selon un premier mode de réalisation du pliage de la bande 10 illustré par la figure 4a, dans un plan de référence PP, on trouve sur un même niveau, la bande 10, les portions d'extrémité 28 de chacune des zones conductrices 13 à 20, les plages de contact externes 24 de chacune des zones conductrices 13 à 20 avec le lecteur de carte, lesdites plages de contact externes étant situées sur la face supérieure 10a du cadre conducteur, l'extrémité 23 ou la partie 18b sur laquelle on fixera la pastille semi-conductrice.

Dans un plan secondaire QQ parallèle au plan de référence PP, et à une distance h = 0,3 - 0,4 mm, on trouve les zones de connexion électrique 26 de chacune des zones conductrices 13 à 20 qui permettront la connexion électrique entre la pastille semi-conductrice et les zones de contact externe 24 situées sur la face 10a de la bande 10, lesdites zones de connexion 26 étant situées sur la face inférieure 10b de la bande 10, et ledit plan secondaire QQ se situant du côté de cette face 10b.

Les plages de contact externes 24 des zones conductrices 13 à 20 situées dans le plan de référence PP et les zones de connexion électrique 26 de ces mêmes zones conductrices 13 à 20 situées dans le plan secondaire QQ sont reliés par les portions de pliage 27 du cadre conducteur, munies des fenêtres 22 et perpendiculaires aux plages 24 et zones de connexion 26. Selon un deuxième mode de réalisation illustré par la figure 4b, les portions de pliages 27 peuvent présenter un angle différent de 90° par rapport aux plages 24 et zones de connexion 26, un angle de 45° par exemple.

Selon un troisième mode de réalisation illustré par la figure 4c, les zones conductrices 13 à 20 comportent un pliage supplémentaire de telle façon que dans un plan intermédiaire RR situé entre le plan de référence PP et le plan secondaire QQ, on trouve la bande 10, les portions d'extrémités 28 des zones conductrices 13 à 20. Des coudes de pliage 29 relient les portions d'extrémité 28 aux plages de contact externes 24, lesdits coudes de pliage 29 pouvant être indifféremment perpendiculaires ou non aux portions d'extrémités 28 et aux zones de contact externes 24.

Les caractéristiques décrites ci-avant sont valables pour chacune des zones conductrices 13 à 20. La zone conductrice 18 constituant le contact de masse présente une continuité de matière avec l'extrémité 23 ou la partie 18b sur lesquelles, selon l'un ou l'autre mode de réalisation de cadre conducteur A, on fixera la pastille semi-conductrice. La configuration particulière illustrée par la figure 2, de la zone conductrice 18, notamment par son pont 18d, permet un pliage plus facile du cadre conducteur A, car ledit pliage se fera dans l'axe du pont 18d.

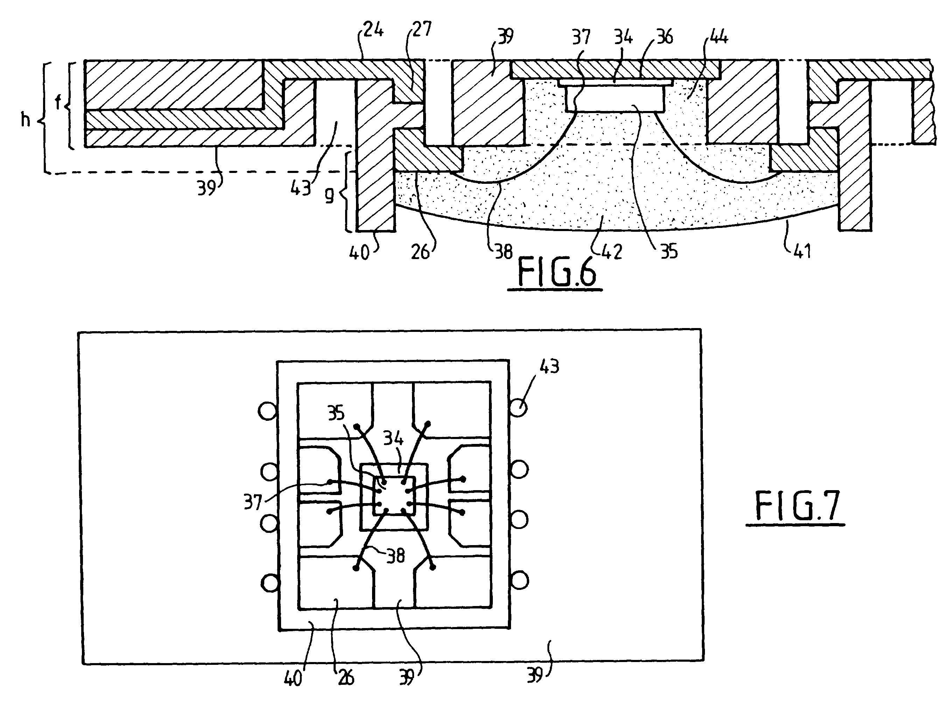

Ce cadre conducteur A ou ensemble de conducteurs électriques plié selon l'un des modes de réalisation illustré par les figures 4a à 4c, est placé dans un moule M dont l'empreinte définit la forme extérieure du module électronique. La figure 5 montre le moule utilisé avec le cadre conducteur plié selon le mode de réalisation illustré par la figure 4c. Le moule comprend une partie fixe 30 et une partie mobile 31.

La périphérie du cadre conducteur A mis en place dans le moule, est pincée entre les parties 30 et 31. L'empreinte de la partie mobile 31 présente une face plane 32. L'empreinte de la partie fixe 30 présente une forme plus complexe. Elle comprend un noyau central 45, une portion étagée 46 qui entoure le noyau central 45, une portion en creux 47 qui entoure la portion étagée 46 et une portion périphérique plane 48. La face plane 32 de la partie moulée 31 d'une part, le noyau central 45, la portion étagée 46 de la partie fixe 30 d'autre part, constituent lesdits moyens de protection du moule M. La partie fixe 30 comporte une buse d'injection 49. L'extrémité 23 ou la partie 18b de la zone conductrice 18 qui comprend la zone de fixation 34 pour ladite pastille semi-conductrice située sur la face inférieure 10b du cadre conducteur A, et les plages de contact externes 24 des zones conductrices 13 à 20 sont appliquées contre la face plane 32 de la partie mobile 31 respectivement par le noyau central 45 et par des plots 33 de petites dimensions faisant saillie hors de la portion périphérique plane 48 de la partie fixe 30 de telle façon que le matériau de moulage ne puisse se déposer entre la face plane 32 de la partie mobile 31 et les plages de contact externes 24 d'une part et l'extrémité 23 ou la partie 18b d'autre part. Les zones de connexion électrique 26 des zones conductrices 13 à 30 et la zone de fixation 34 de la pastille semi-conductrice sont plaquées respectivement sur la portion étagée 46 de l'empreinte de la partie fixe 30 du moule M par des plots 49 faisant saillie hors de la face plane 32 de la partie mobile 31 et sur le noyau central 45 par la face plane 32 de la partie mobile 31 de telle façon que le matériau de moulage ne puisse se déposer entre la zone de fixation 34 de la pastille semi-conductrice et le noyau central 45 d'une part, entre les zones de connexion électrique 26 et la portion étagée 46 d'autre part.

Dans l'étape suivante, on réalise le moulage du cadre conducteur A par injection du matériau de moulage selon la configuration spatiale définie par l'empreinte du moule M illustrée par la figure 5. Pour un pliage de cadre conducteur tel que défini dans les figures 4b et 4c, le moulage a pour résultat que le matériau de moulage enrobe complètement les portions d'extrémité 28 des zones conductrices 13 à 20, les coudes de pliages 29 et les portions de pliage 27 avec leur fenêtres correspondantes 22 qui permettent une meilleure circulation du matériau de moulage.

Le moulage des portions d'extrémité 28, des coudes de pliage 29 et des portions de pliage 27 permet d'obtenir un ensemble A de conducteurs électriques 13 à 20 ancré dans le matériau de moulage, évitant les problèmes d'adhérence d'un ensemble plan de conducteurs électriques sur le matériau de moulage. Selon le premier mode de réalisation du pliage du cadre conducteur A illustré par la figure 4a, les portions d'extrémités 28 situées dans le plan de référence PP, sont appliquées contre la face plane 32 de la partie mobile 31 du moule M, le matériau de moulage ne venant recouvrir que la face côté 10b des portions d'extrémité 28.

L'empreinte de la partie mobile 31 du moule M peut présenter une forme différente comprenant une face plane 32 et un noyau périphérique plan faisant saillie hors de la face plane 32, les portions d'extrémités 28 et les coudes de pliage 29 des figures 4b, 4c étant appliqués contre le noyau périphérique plan de la partie mobile 31 de telle façon que la matériau de moulage ne puisse se déposer entre le noyau périphérique plan et, les portions d'extrémité 28 d'une part et les coudes de pliage 29 d'autre part.

Le matériau de moulage utilisé est une résine époxy, ou une matière de mêmes propriétés physico-chimiques, ou une substance identique à celle du corps de carte telle que l'ABS (acrylonitryl-butadière-styrène). Cette dernière possibilité permet d'obtenir un ensemble corps de carte, module électronique homogéne mécaniquement.

Dans l'étape suivante, la pièce est démoulée. On obtient ainsi une pièce moulée sur le cadre conducteur A qui définit une cavité 41 dans laquelle la zone de fixation 34 de la pastille semi-conductrice et les zones de connexion électrique 26 sont apparentes.

On fixe la pastille semi-conductrice 35 sur la zone de fixation 34 par un colle conductrice 36. On réalise une liaison électrique entre les bornes 37 de la pastille semi-conductrice 35 et les zones de connexion électrique 26 par des fils conducteurs 38. La pièce moulée est composée d'une plate forme moulée 39 d'épaisseur f présentant une ouverture (44) entourée par le matériau de moulage où se situe la pastille semi-conductrice et d'une barrière moulée 40 d'épaisseur g obtenue par la portion en creux 47 de la partie fixe 30 du moule M, l'addition de f et g correspond en fait à l'épaisseur du module électronique destiné à être incorporé dans un corps de carte. Les zones de connexion électrique 26 reposent sur la plate forme moulée 39 de telle sorte que les zones de contact externes 24 additionnées des portions de pliage 27 et des zones de connexion électrique 26 ont une caractéristique dimensionnelle h=0,3 - 0,4 mm inférieure à f + g épaisseur du module électronique. La barrière moulée 40 délimite la cavité 41 dans laquelle sont disposés la pastille semi-conductrice 35 collée sur la zone de fixation 34, la plate forme moulée 39 avec son ouverture 44, les zones de connexion électrique 26 reposant sur la plate forme moulée 39 et les fils conducteurs 38 reliant les bornes 37 de la pastille semi-conductrice 35 auxdites zones de connexion électrique 26. Un matériau d'enrobage isolant 42 vient recouvrir dans la cavité 41, la pastille semi-conductrice 35, la plate-forme moulée 39 avec son ouverture 44, les fils conducteurs 38 et les zones de connexion électrique 26. La barrière moulée 40 évite l'écoulement du matériau d' enrobage isolant 35. Le module électronique ainsi obtenu en le séparant du reste de la bande métallique 10 par découpage des ponts d'interconnexion 21, est représenté sur la figure 6.

La figure 7 représente une vue de dessous du module électronique obtenu avant le dépôt du matériau d'enrobage isolant 42.

Le modèle électronique moulé étant ainsi fabriqué, il ne reste plus qu'à l'insérer dans une carte à mémoire. La technique de fixation est celle décrite dans la demande de brevet européen 0254640, les picots de pré-fixation pouvant pénétrer dans les orifices 43 créés par les plots 33 de la partie fixe 30 du moule M. Un autre mode de réalisation décrit dans la demande de brevet français 2 609 821 serait de mouler le corps de carte autour du module électronique moulé en utilisant dans les deux opérations de moulage la même matière de moulage, afin d'obtenir un ensemble d'un seul tenant homogène mécaniquement.

Selon une variante de réalisation du module électronique, après la fixation des fils conducteurs entre les bornes de la pastille et les zones de connexion électrique on ne remplit pas la cavité avec le matériau d'enrobage isolant. On se contente, par exemple par pulvérisation, de recouvrir les fils conducteurs d'une mince couche de matériau électriquement isolant. Dans ce cas il faut que les hauteurs f et g soient définies avec une grande précision de telle manière que la face libre de la barrière 40 vienne précisément en butée contre la face interne de la cavité qui est ménagée dans le corps de la carte. Ainsi la bornière 40 constitue une entretoise qui interdit l'enfoncement du fond de la cavité du corps de carte et qui protège ainsi mécaniquement la pastille 35 et les fils conducteurs 38.

## Revendications

1. Procédé de réalisation d'un module électronique d'une carte à mémoire électronique comprenant les étapes suivantes:
a) on fournit un ensemble (A) de conducteurs électriques (13 à 20) formant cadre conducteur (lead-frame) présentant une première (10a) et une deuxième face (10b), pour définir des plages de contact externe (24) pour ladite carte situées sur ladite première face dudit ensemble, lesdites plages de contact externe étant disposées dans un premier plan (PP), des zones de connexion électrique (26) et une zone de fixation (34) d'une pastille semi-conductrice (35) situées sur ladite deuxième face dudit ensemble et des portions d'extrémité (28) raccordées à la périphérie des plages de contact externe par des coudes de pliage (29) de telle manière que lesdites portions d'extrémité soient disposées dans un plan intermédiaire (RR) disposé parallèle et en retrait par rapport audit premier plan;
b) on fournit un moule (M) dont l'empreinte définit la forme extérieure dudit module électronique destiné à être incorporé dans une carte à mémoire, ladite empreinte présentant une face sensiblement plane pour constituer la face externe du module électronique, ledit moule comportant des moyens de protection pour éviter le dépôt du matériau de moulage entre lesdits moyens de protection et lesdites plages de contact externe (24), lesdites zones de connexion électrique (26), et ladite zone de fixation d'une pastille semi-conductrice (34), lesdits moyens de protection comportant des moyens pour maintenir les plages de contact externe contre ladite face sensiblement plane;
c) on place ledit ensemble (A) de conducteurs électriques (13 à 20) dans ledit moule (M);
d) on injecte dans ledit moule ledit matériau de moulage pour que celui-ci remplisse ladite empreinte dudit moule, lesdites portions d'extrémité (28) étant alors noyées dans ledit matériau de moulage;
e) on démoule la pièce ainsi obtenue;
f) on fixe ladite pastille semi-conductrice (35) sur ladite zone de fixation (34); et
g) on réalise une liaison électrique entre les bornes (37) de ladite pastille semi-conductrice (35) et lesdites zones de connexion électrique (26).

2. Procédé selon la revendication 1, dans lequel on réalise un pliage sur ledit ensemble (A) de conducteurs électriques (13 à 20) avant que ledit ensemble ne soit placé dans ledit moule (M), de telle manière que lesdites plages de contact externe (24) et ladite zone de fixation (34) de ladite pastille semi-conductrice (35) se situent dans ledit premier plan (PP) et que lesdites zones de connexion électrique (26) se situent dans un plan secondaire (QQ) parallèle audit premier plan (PP), ledit plan secondaire (QQ) étant situé par rapport audit premier plan (PP) du côté de ladite deuxième face (10b) dudit ensemble.

3. Procédé selon la revendication 2, dans lequel ledit pliage dudit ensemble (A) de conducteurs électriques (13 à 20) comprend des portions de pliage (27) dudit ensemble (A), reliant lesdites plages de contact externe (24) situées dans ledit premier plan (PP) et lesdites zones de connexion électrique (26) situées dans ledit plan secondaire (QQ), lesdites portions de pliage (27) comportant des fenêtres (22) de telle manière que ledit matériau de moulage circule plus facilement.

4. Procédé selon la revendication 2, dans lequel ledit pliage dudit ensemble (A) de conducteurs électriques (13 à 20) comprend de plus des portions d'extrémité (28) desdits conducteurs électriques (13 à 20) situées dans ledit plan intermédiaire (RR) entre ledit premier plan (PP) et ledit plan secondaire (QQ), et des coudes de pliage (29) reliant lesdites portions d'extrémité (28) auxdites plages de contact externe (24).

5. Module électronique d'une carte à mémoire électronique comprenant un ensemble (A) de conducteurs électriques (13 à 20) formant cadre conducteur (lead-frame), présentant une première (10a) et une deuxième face (10b), pour définir des plages de contact externe (24) de ladite carte situées sur ladite première face dudit ensemble, lesdites plages de contact externe étant disposées dans un premier plan (PP), des zones de connexion électrique (26) et une zone de fixation (34) d'une pastille semi-conductrice (35) situées sur ladite deuxième face dudit ensemble, une pièce moulée définissant une cavité (41) pour une pastille semi-conductrice (35), et présentant une face sensiblement plane dans laquelle sont disposées lesdites plages de contact externe (24), une pastille semi-conductrice (35) fixée sur ladite zone de fixation (34) et des moyens de liaison (38) pour relier électriquement les bornes (37) de ladite pastille auxdites zones de connexion électrique, ledit cadre conducteur comprenant en outre des portions d'extrémité (28) caractérisé en ce que ces portions d'extrémité sont raccordées à la périphérie des plages de contact externe par des coudes de pliage (29) de telle manière que lesdites portions d'extrémité soient disposées dans un plan intermédiaire (RR) situé parallèle et en retrait par rapport audit premier plan, lesdites portions d'extrémité étant noyées dans ladite pièce moulée.

6. Module électronique selon la revendication 5, dans lequel ladite pièce moulée est composée d'une part d'une plate-forme moulée (39) située du côté de ladite deuxième face (10b) dudit ensemble (A), lesdites zones de connexion électrique (26) reposant sur ladite plate-forme moulée (39), et d'autre part d'une barrière moulée (40), située du côté de ladite deuxième face dudit ensemble, délimitant ladite cavité dans laquelle sont disposés ladite pastille semi-conductrice, ladite plate-forme moulée, lesdites zones de connexion électrique et lesdits moyens de liaison pour relier électriquement lesdites bornes de ladite pastille auxdites zones de connexion électrique.

7. Module électronique selon la revendication 5, dans lequel ledit ensemble de conducteurs électriques comporte un pliage de telle manière que lesdites plages de contact externe (24) et ladite zone de fixation (34) de ladite pastille semi-conductrice (35) se situent dans ledit premier plan (PP) et que lesdites zones de connexion électrique (26) se situent dans un plan secondaire (QQ) parallèle audit premier plan (PP), ledit plan secondaire (QQ) étant situé du côté de ladite deuxième face dudit ensemble.

8. Module électronique selon la revendication 7, dans lequel ledit pliage dudit ensemble (A) de conducteurs électriques (13 à 20) comprend des portions de pliage (27) dudit ensemble (A), reliant lesdites plages de contact externe (24) situées dans ledit premier plan (PP) et lesdites zones de connexion électrique (26) situées dans ledit plan secondaire (QQ), lesdites portions de pliage (27) comportant des fenêtres (22).

9. Module électronique selon la revendication 7, dans lequel ledit pliage dudit ensemble (A) de conducteurs électriques (13 à 20) comprend de plus des portions d'extrémité (28) desdits conducteurs électriques (13 à 20) et situés dans ledit plan intermédiaire (RR) entre ledit premier plan (PP) et ledit plan secondaire (QQ) et des coudes de pliage (29) reliant lesdites portions d'extrémité (28) auxdites plages de contact externe (24).

10. Module électronique selon la revendication 9, dans lequel lesdites portions de pliage (27), lesdites portions d'extrémité (28), et lesdits coudes de pliage (29) sont moulés sur leurs deux faces assurant audit ensemble (A) de conducteurs électriques (13 à 20) un ancrage dans le matériau de moulage.

11. Module électronique selon la revendication 5, dans lequel le matériau de moulage est identique à celui du corps de carte dans lequel va être inséré ledit module électronique.

12. Module électronique selon la revendication 11, dans lequel le matériau de moulage est de l'ABS.

13. Module électronique selon la revendication 5, comprenant en outre un matériau isolant d'enrobage remplissant sensiblement ladite cavité.

## Claims

1. Method for producing an electronic module of an electronic memory card comprising the following steps:
a) providing an assembly (A) of electrical conductors (13 to 20) forming a lead-frame having a first (10a) and second (10b) face, to define external contact regions (24) for said card located on said first face of said assembly, said external contact regions being arranged in a first plane (PP), electrical connection zones (26) and a zone (34) for fastening a semi-conductor chip (35) located on said second face of said assembly and end portions (28) connected to the periphery of the external contact regions by bending elbows (29) such that said end portions are arranged in an intermediate plane (RR) arranged parallel to and set back from said first plane;
b) providing a mould (M) the impression of which defines the external shape of said electronic module intended to be incorporated into a memory card, said impression having a substantially plane face to constitute the outer face of the electronic module, said mould having protective means to prevent the depositing of the moulding material between said protective means and said external contact regions (24), said electrical connection zones (26) and said zone (34) for fastening a semi-conductor chip, said protective means comprising means for holding the external contact regions against said substantially plane face;
c) placing said assembly (A) of electrical conductors (13 to 20) in said mould (M);
d) injecting said moulding material into said mould so that the moulding material fills said impression of said mould, said end portions (28) then being embedded in said moulding material;
e) withdrawing from the mould the part thus obtained;
f) fastening said semi-conductor chip (35) on said fastening zone (34); and
g) forming an electrical coupling between the terminals (37) of said semi-conductor chip (35) and said electrical connection zones (26).

2. Method according to Claim 1, in which bending is carried out on said assembly (A) of electrical conductors (13 to 20) before said assembly is placed in said mould (M), such that said external contact regions (24) and said zone (34) for fastening said semi-conductor chip (35) are located in said first plane (PP) and such that said electrical connection zones (26) are located in a secondary plane (QQ) parallel to said first plane (PP), said secondary plane (QQ) being located relative to said first plane (PP) on the side of said second face (10b) of said assembly.

3. Method according to Claim 2, in which said bending of said assembly (A) of electrical conductors (13 to 20) comprises bending portions (27) of said assembly (A), coupling said external contact regions (24) located in said first plane (PP) with said electrical connection zones (26) located in said secondary plane (QQ), said bending portions (27) including windows (22) such that said moulding material can circulate more easily.

4. Method according to Claim 2, in which said bending of said assembly (A) of electrical conductors (13 to 20) further comprises end portions (28) of said electrical conductors (13 to 20) located in said intermediate plane (RR) between said first plane (PP) and said secondary plane (QQ), and bending elbows (29) coupling said end portions (28) with said external contact regions (24).

5. An electronic module of an electronic memory card comprising an assembly (A) of electrical conductors (13 to 20) forming a lead-frame, having a first (10a) and a second (10b) face, to define external contact regions (24) of said card located on said first face of said assembly, said external contact regions being arranged in a first plane (PP), electrical connection zones (26) and a zone (34) for fastening a semi-conductor chip (35) being located on said second face of said assembly, a moulded part defining a cavity (41) for a semi-conductor chip (35), and having a substantially plane face in which are arranged said external contact regions (24), a semi-conductor chip (35) fastened to said fastening zone (34) and coupling means (38) for electrically connecting the terminals (37) of said chip with said electrical connection zones, said lead-frame further comprising end portions (28), characterised in that these end portions are connected to the periphery of the external contact regions by bending elbows (29) such that said end portions are arranged in an intermediate plane (RR) located parallel to and set back from said first plane, said end portions being embedded in said moulded part.

6. Electronic module according to Claim 5, in which said moulded part is composed on the one hand of a moulded platform (39) located on the side of said second face (10b) of said assembly (A), said electrical connection zones (26) resting on said moulded platform (39), and on the other hand a moulded barrier (40), located on the side of said second face of said assembly, delimiting said cavity in which are arranged said semi-conductor chip, said moulded platform, said electrical connection zones and said coupling means for electrically coupling said terminals of said chip with said electrical connection zones.

7. Electronic module according to Claim 5, in which said assembly of electrical conductors comprises a bending such that said external contact regions (24) and said zone (34) for fastening said semi-conductor chip (35) are located in said first plane (PP) and that said electrical connection zones (26) are located in a secondary plane (QQ) parallel to said first plane (PP), said secondary plane (QQ) being located on the side of said second face of said assembly.

8. Electronic module according to Claim 7, in which said bending of said assembly (A) of electrical conductors (13 to 20) comprises bending portions (27) of said assembly (A), coupling said external contact regions (24) located in said first plane (PP) with said electrical connection zones (26) located in said secondary plane (QQ), said bending portions (27) including windows (22).

9. Electronic module according to Claim 7, in which said bending of said assembly (A) of electrical conductors (13 to 20) further comprises end portions (28) of said electrical conductors (13 to 20) located in said intermediate plane (RR) between said first plane (PP) and said secondary plane (QQ) and bending elbows (29) coupling said end portions (28) with said external contact regions (24).

10. Electronic module according to Claim 9, in which said bending portions (27), said end portions (28) and said bending elbows (29) are moulded on both their faces, giving said assembly (A) of electrical conductors (13 to 20) an anchorage in the moulding material.

11. Electronic module according to Claim 5, in which the moulding material is identical to that of the body of the card into which said electronic module will be inserted.

12. Electronic module according to Claim 11, in which the moulding material is ABS.

13. Electronic module according to Claim 5, further comprising an insulating coating material substantially filling said cavity.

## Patentansprüche

1. Verfahren zur Herstellung eines elektronischen Moduls für eine elektronische Speicherkarte, umfassend die folgenden Schritte:
a) Bereitstellen einer Baugruppe (A) aus elektrischen Leitern (13 bis 20), welche einen Leiterrahmen (Lead-Frame) mit einer ersten Stimseite (10a) und einer zweiten Stirnseite (10b) zum Festlegen von auf der ersten Stirnseite der Baugruppe befindlichen äußeren Kontaktbereichen (24) für die Karte bilden, wobei die äußeren Kontaktbereiche in einer ersten Ebene (PP) angeordnet sind, elektrische Verbindungszonen (26) und eine Zone (34) zur Befestigung eines Halbleiter-Chips (35) auf der zweiten Stimseite der Baugruppe liegen und Endabschnitte (28) über Falzkröpfungen (29) derart an die Peripherie der äußeren Kontaktbereiche anschließen, dass diese Endabschnitte in einer in Bezug auf die erste Ebene parallel und zurückspringend angeordneten Zwischenebene (RR) liegen;
b) Bereitstellen einer Form (M), deren Matrize die Außenform des in eine Speicher karte zu inkorporierenden elektronischen Moduls festlegt, welche Matrize eine im wesentlichen ebene Fläche zur Bildung der Außenseite des elektronischen Moduls aufweist, wobei die Form Schutzeinrichtungen zur Vermeidung des Absetzens von Formungsmaterial zwischen den Schutzeinrichtungen und den äußeren Kontaktbereichen (24), den elektrischen Verbindungszonen (26) und der Zone (34) zur Befestigung eines Halbleiter-Chips aufweist, welche Schutzeinrichtungen Mittel zum Halten der äußeren Kontaktbereiche an der im wesentlichen ebenen Fläche aufweisen;
c) Anordnen der Baugruppe (A) aus elektrischen Leitern (13 bis 20) in der Form (M);
d) Einspritzen des Formungsmaterials in die Form, damit dieses die Matrize der Form ausfüllt, wobei dann die Endabschnitte (28) im Formungsmaterial versenkt sind;
e) Entfernen des so erhaltenen Stücks aus der Form;
f) Befestigen des Halbleiter-Chips (35) auf der Befestigungszone (34); und
g) Herstellen einer elektrischen Verbindung zwischen den Anschlussklemmen (37) des Halbleiter-Chips (35) und den elektrischen Verbindungszonen (26).

2. Verfahren nach Anspruch 1, bei welchem eine Falzung an der Baugruppe (A) aus elektrischen Leitern (13 bis 20) vor dem Anordnen der Baugruppe in der Form (M) derart vorgenommen wird, dass die äußeren Kontaktbereiche (24) und die Zone (34) zur Befestigung des Halbleiter-Chips (35) in der ersten Ebene (PP) und die elektrischen Verbindungszonen (26) in einer zur ersten Ebenen (PP) parallelen, zweiten Ebene (QQ) zu liegen kommen, wobei die zweite Ebene (QQ) in Bezug auf die erste Ebene (PP) auf der Seite der zweiten Stirnseite (10b) der Baugruppe liegt.

3. Verfahren nach Anspruch 2, bei welchem die Falzung der Baugruppe (A) aus elektrischen Leitern (13 bis 20) Falzabschnitte (27) der Baugruppe (A) umfaßt, welche die in der ersten Ebene (PP) liegenden äußeren Kontaktbereiche (24) und die in der zweiten Ebene (QQ) befindlichen elektrischen Verbindungszonen (26) miteinander verbinden, wobei die Falzbereiche (27) Schlitze (22) für ein leichteres Zirkulieren des Formungsmaterials aufweisen.

4. Verfahren nach Anspruch 2, bei welchem die Falzung der Baugruppe (A) aus elektrischen Leitern (13 bis 20) weiters in der Zwischenebene (RR) zwischen der ersten Ebene (PP) und der zweiten Ebene (QQ) liegende Endabschnitte (28) der elektrischen Leiter (13 bis 20) und diese Endabschnitte (28) mit den äußeren Kontaktbereichen (24) verbindende Falzkröpfungen (29) aufweist.

5. Elektronischer Modul für eine elektronische Speicherkarte, umfassend eine Baugruppe (A) aus elektrischen Leitern (13 bis 20), die einen Leiterrahmen (Lead-Frame) mit einer ersten Stirnseite (10a) und einer zweiten Stirnseite (10b) zum Festlegen von auf der ersten Stirnseite der Baugruppe befindlichen äußeren Kontaktbereichen (24) für die Karte bilden, wobei die äußeren Kontaktbereiche in einer ersten Ebene (PP) angeordnet sind, elektrische Verbindungszonen (26) und eine Zone (34) zur Befestigung eines Halbleiter-Chips (35) auf der zweiten Stirnseite der Baugruppe liegen, ein einen Hohlraum (41) für einen Halbleiter-Chip (35) begrenzendes Formstück, welches eine im wesentlichen ebene Fläche aufweist, in welcher die äußeren Kontaktbereiche (24) angeordnet sind, einen auf der Befestigungszone (34) befestigten Halbleiter-Chip (35) und Verbindungsmittel (38) zum elektrischen Verbinden der Anschlußklemmen (37) des Chips mit den elektrischen Verbindungszonen, wobei der Leiterrahmen außerdem Endabschnitte (28) aufweist, welche Endabschnitte über Falzkröpfungen (29) derart an die Peripherie der äußeren Kontaktbereiche anschließen, dass diese Endabschnitte in einer in Bezug auf die erste Ebene parallel und zurückspringend angeordneten Zwischenebene (RR) liegen, wobei die Endabschitte in dem Formstück versenkt sind.

6. Elektronischer Modul nach Anspruch 5, bei welchem das Formstück einerseits aus einer auf der Seite der zweiten Stirnseite (10b) der Baugruppe (A) angeordneten geformten Plattform (39) gebildet ist, wobei die elektrischen Verbindungszonen (26) auf der geformten Plattform (39) ruhen, und andererseits aus einer geformten Barriere (40) gebildet ist, welche auf der Seite der zweiten Stimseite der Baugruppe angeordnet ist und den Hohlraum, in welchem der Halbleiter-Chip, die geformte Plattform, die elektrischen Verbindungszonen und die Verbindungsmittel zum elektrischen Verbinden der Anschlussklemmen des Chips mit den elektrischen Verbindungszonen angeordnet sind, begrenzt.

7. Elektronischer Modul nach Anspruch 5, bei welchem die Baugruppe aus elektrischen Leitern eine Falzung aufweist, so dass die äußeren Kontaktbereiche (24) und die Zone (34) zur Befestigung des Halbleiter-Chips (35) in der ersten Ebene (PP) liegen und die elektrischen Verbindungszonen (26) in einer zur ersten Ebene (PP) parallelen, zweiten Ebene (QQ) liegen, wobei die zweite Ebene (QQ) auf der Seite der zweiten Stirnseite der Baugruppe liegt.

8. Elektronischer Modul nach Anspruch 7, bei welchem die Falzung der Baugruppe (A) aus elektrischen Leitern (13 bis 20) Falzabschnitte (27) der Baugruppe (A) umfaßt, welche die in der ersten Ebene (PP) liegenden äußeren Kontaktbereiche (24) und die in der zweiten Ebene (QQ) liegenden elektrischen Verbindungszonen (26) miteinander verbinden, wobei die Falzabschnitte (27) Schlitze (22) aufweisen.

9. Elektronischer Modul nach Anspruch 7, bei welchem die Falzung der Baugruppe (A) aus elektrischen Leitern (13 bis 20) weiters Endabschnitte (28) der elektrischen Leiter (13 bis 20), welche in der Zwischenebene (RR) zwischen der ersten Ebene (PP) und der zweiten Ebene (QQ) angeordnet sind, und Falzkröpfungen (29), welche die Endabschnitte (28) mit den äußeren Kontaktbereichen (24) verbinden, aufweist.

10. Elektronischer Modul nach Anspruch 9, bei welchem die Falzabschnitte (27), die Endabschnitte (28) und die Falzkröpfungen (29) auf beiden Seiten angeformt sind, wodurch eine Verankerung der Baugruppe (A) aus elektrischen Leitern (13 bis 20) im Formungsmaterial gewährleistet ist.

11. Elektronischer Modul nach Anspruch 5, bei welchem das Formungsmaterial identisch mit jenem des Kartenkörpers ist, in welchen der elektronische Modul eingesetzt wird.

12. Elektronischer Modul nach Anspruch 11, bei welchem das Formungsmaterial ABS ist.

13. Elektronischer Modul nach Anspruch 5, welcher außerdem ein den Hohlraum im wesentlichen ausfüllendes isolierendes Hüllmaterial aufweist.
